# EUROPEAN PATENT SPECIFICATION

(11) **EP 3 403 281 B1**
(45) Date of publication and mention of the grant of the patent: **12.10.2022**
(21) Application number: 16871752.8
(22) Date of filing: 29.12.2016
(51) Int. Cl.: H01L 29/786, H01L 29/66, H01L 29/24

(54) **ACTIVE LAYER, THIN FILM TRANSISTOR, ARRAY SUBSTRATE, AND DISPLAY APPARATUS AND FABRICATION METHODS**
AKTIVE SCHICHT, DÜNNSCHICHTTRANSISTOR, ARRAY-SUBSTRAT UND ANZEIGEVORRICHTUNG UND HERSTELLUNGSVERFAHREN
COUCHE ACTIVE, TRANSISTOR À COUCHES MINCES, SUBSTRAT MATRICIEL AINSI QUE DISPOSITIF D'AFFICHAGE ET PROCÉDÉS DE FABRICATION

(30) Priority: 15.01.2016 CN 201610027679
(43) Date of publication of application: 21.11.2018
(73) Proprietor: BOE Technology Group Co., Ltd., Beijing 100015 (CN); South China University of Technology, Guangdong 510640 (CN)
(72) Inventor: YAN, Liangchen, Beijing 100176 (CN); YUAN, Guangcai, Beijing 100176 (CN); XU, Xiaoguang, Beijing 100176 (CN); WANG, Lei, Beijing 100176 (CN); PENG, Junbiao, Beijing 100176 (CN); LAN, Linfeng, Beijing 100176 (CN)
(74) Representative: Cohausz & Florack
(86) International application number: PCT/CN2016/112952
(87) International publication number: WO 2017/121243

(56) References cited:
- CN-A- 104 952 914
- CN-A- 104 952 914
- CN-A- 105 161 423
- CN-A- 105 161 423
- CN-A- 105 655 389
- US-A1- 2011 101 459
- US-A1- 2011 180 763
- US-A1- 2014 139 772
- US-A1- 2017 077 307

## Description

### FIELD OF THE DISCLOSURE

The present disclosure generally relates to flat panel display technologies and, more particularly, relates to an active layer, a thin film transistor, an array substrate, and a display apparatus, and their fabrication methods.

### BACKGROUND

In flat panel displays, especially in electroluminescence displays, thin film transistors (TFT) as core components have been receiving more and more attention. Generally, a thin film transistor includes a substrate, a gate electrode, a gate insulating layer, an active layer, a source electrode, and a drain electrode. Together with the active layer, the source and drain electrodes covering the active layer form a back channel structure to reduce the size and parasitic capacitance of the thin film transistor.

Generally, the back channel structure in the thin film transistor is made of silicon and other semiconductor oxide material. A back channel etched thin film transistor made of oxide-based semiconductor materials, such as tin oxide and zinc oxide, may provide high mobility, desired transparency to visible light, and uniformity in large area, and hence is widely used. However, oxide-based semiconductor materials have low conductivity, and are generally fabricated by using a radio frequency (RF) sputtering process.

The disclosed active layer, thin film transistor, array substrate, and display apparatus, and their fabrication methods are directed to at least partially alleviate one or more problems set forth above and to solve other problems in the art.

### BRIEF SUMMARY OF THE DISCLOSURE

The present invention concerns a method for manufacturing a thin film transistor as defined in claim 1.

The present disclosure provides an active layer, a thin film transistor, an array substrate, and a display apparatus, and their fabrication methods.

According to the invention, a method for fabricating an active layer in a thin film transistor involves forming a thin film by a direct current (DC) sputtering process; and etching the thin film to form the active layer. The thin film is made of a material selected to provide the active layer with a carrier concentration of at least approximately 1×10¹⁷cm⁻³ and a carrier mobility of at least approximately 20 cm²/Vs.

Optionally, the carrier concentration in the active layer is greater than or equal to approximately 1×10¹⁸cm⁻³; and the carrier mobility in the active layer is greater than or equal to approximately 30cm²/Vs.

According to the invention, the zirconium indium oxide has a chemical formula of Zr₆ ln₉₄O₁₀₀ , or Zr₁₁ In₈₉ O₁₀₀ , or Zr₁₆ ln₈₄ 0₁₀₀ .

According to the invention, the thin film is etched by a wet etching process.

According to an example, not falling within the scope of the claims, the wet etching process includes: etching a zirconium indium oxide thin film at an etching rate of greater than or equal to approximately 60 nm/min in a phosphoric acid having a weight concentration of approximately 40 % to 60 %; and annealing the zirconium indium oxide thin film in air at a temperature between approximately 150 °C and 220 °C for at least approximately 30 minutes. An etching rate of the zirconium indium oxide thin film after annealing is dropped to be less than or equal to 10 nm/min.

According to the invention, the wet etching process includes: etching a zirconium indium oxide thin film at an etching rate of greater than or equal to approximately 60 nm/min in a phosphoric acid having a weight concentration of approximately 50 %; and annealing the zirconium indium oxide thin film in air at a temperature approximately 200 °C for at least approximately 30 minutes. Optionally, an etching rate of the zirconium indium oxide thin film after annealing is dropped to be less than or equal to approximately 5 nm/min.

It is described a method for fabricating a thin film transistor is provided by forming a gate electrode thin film on a substrate by a direct current (DC) sputtering process; etching the gate electrode thin film to form a gate electrode; forming a gate insulating layer on the gate electrode; forming an active layer thin film by a DC sputtering process on the gate insulating layer; etching the active layer thin film by a wet etching process followed by an annealing process to form an active layer; and forming a source/drain thin film by a DC sputtering process on the active layer; and etching the source/drain thin film to form a source electrode and a drain electrode.

Optionally, the method further includes: selecting a material suitable for the DC sputtering process for forming the active layer thin film, such that the active layer has a carrier concentration of at least approximately 1×10¹⁷cm⁻³ and a carrier mobility of at least approximately 20 cm²/Vs.

Optionally, the carrier concentration in the active layer is greater than or equal to approximately 1×10¹⁸cm⁻³; and the carrier mobility in the active layer is greater than or equal to approximately 30cm²/Vs.

Optionally, the material is selected from zirconium indium oxide, hafnium zinc oxide, indium tin oxide, zinc oxide, Ln-doped zinc oxide, and a combination thereof.

Optionally, the zirconium indium oxide has a chemical formula of ZrₓIn₁₀₀₋ₓO_{y}, where 0.1≤x≤20 and y>0.

Optionally, the wet etching process for etching the active layer thin film includes: etching a zirconium indium oxide thin film at an etching rate of greater than or equal to approximately 60 nm/min in a phosphoric acid having a weight concentration of approximately 40 % to 60 %; and annealing the zirconium indium oxide thin film in air at a temperature between approximately 150 °C and 220 °C for at least approximately 30 minutes. An etching rate of the zirconium indium oxide thin film after annealing is dropped to be less than or equal to 10 nm/min.

Optionally, the wet etching process for etching the active layer thin film includes: etching a zirconium indium oxide thin film at an etching rate of greater than or equal to approximately 60 nm/min in a phosphoric acid having a weight concentration of approximately 50 %; and annealing the zirconium indium oxide thin film in air at a temperature approximately 200 °C for at least approximately 30 minutes. An etching rate of the zirconium indium oxide thin film after annealing is dropped to be less than or equal to approximately 5 nm/min.

Optionally, the gate insulating layer is formed by an electrochemical oxidation method on the gate electrode.

Optionally, each of etching the gate electrode thin film and etching the source/drain thin film includes a wet etching process.

A thin film transistor includes an active layer, made of a direct-current-sputtered material providing the active layer with a carrier concentration of at least approximately 1×10¹⁷cm⁻³ and a carrier mobility of at least approximately 20 cm²/Vs. The thin film transistor is free of an etch stop layer.

Optionally, the carrier concentration in the active layer is greater than or equal to approximately 1×10¹⁸cm⁻³; and the carrier mobility in the active layer is greater than or equal to approximately 30cm²/Vs.

Optionally, the direct-current-sputtered material includes one or more selected from zirconium indium oxide, hafnium zinc oxide, indium tin oxide, zinc oxide, and Ln-doped zinc oxide.

Optionally, the zirconium indium oxide has a chemical formula of ZrₓIn₁₀₀₋ₓO_{y}, where 0.1≤x≤20 and y>0.

Optionally, the thin film transistor further includes: a gate electrode on the substrate; a gate insulating layer covering the gate electrode; and a source electrode and a drain electrode. The active layer is on the gate insulating layer, and the source electrode and the drain electrode are on the active layer and both in contact with the active layer.

Optionally, the gate electrode has a thickness of approximately 100 nm to 800 nm; the gate insulating layer has a thickness of approximately 30 nm to 600 nm; the active layer has a thickness of approximately 10 nm to 200 nm; and the source electrode and the drain electrode have a thickness of approximately 100 nm to 1000 nm.

Optionally, the gate electrode is made of a material including one or more of aluminum, aluminum alloy, tantalum, tantalum alloy, and molybdenum.

Optionally, the gate insulating layer is made of an insulating oxide selected from aluminum oxide, molybdenum oxide, tantalum oxide, aluminum neodymium oxide, and a combination thereof.

Optionally, the source electrode and the drain electrode are made of a conductive metal, including one or more selected from aluminum, molybdenum, tantalum, and aluminum neodymium alloy.

Optionally, the substrate is coated with a buffer layer or a water-oxygen-barrier layer.

An array substrate including the disclosed thin film transistor is provided.

A display apparatus including the disclosed array substrate is provided.

Other aspects of the present disclosure can be understood by those skilled in the art in light of the description, the claims, and the drawings of the present disclosure.

### BRIEF DESCRIPTION OF THE DRAWINGS

The following drawings are merely examples for illustrative purposes according to various disclosed embodiments and are not intended to limit the scope of the present disclosure.
FIG. 1 illustrates a schematic view of an exemplary back-channel-etched oxide thin film transistor according to some embodiments of present disclosure;
FIG. 2 illustrates a polarizing microscope scanning view of another exemplary back-channel-etched oxide thin film transistor according to some embodiments of present disclosure;
FIG. 3 illustrates output characteristics curves of certain exemplary back-channel-etched oxide thin film transistors according to some embodiments of present disclosure;
FIG. 4 illustrates a flow chart of a fabrication method for an exemplary active layer according to some embodiments of present disclosure; and
FIG. 5 illustrates a flow chart of a fabrication method for an exemplary thin film transistor according to some embodiments of present disclosure.

### DETAILED DESCRIPTION

Reference will now be made in detail to exemplary embodiments of the disclosure, which are illustrated in the accompanying drawings. Wherever possible, the same reference numbers will be used throughout the drawings to refer to the same or like parts. Shapes and sizes in the drawings do not reflect the true proportions of the components. It should be understood that the exemplary embodiments described herein are only intended to illustrate and explain the present invention and not to limit the present invention. Other applications, advantages, alternations, modifications, or equivalents to the disclosed embodiments are obvious to those skilled in the art and are intended to be encompassed within the scope of the present disclosure.

An active layer, a thin film transistor, an array substrate, and a display apparatus, and their fabrication methods are provided according to some embodiments of the present disclosure. For example, an active layer in a thin film transistor may be fabricated by forming a thin film by a direct current (DC) sputtering process; and etching the thin film to form the active layer. The thin film may be made of a material selected to provide the active layer with a carrier concentration of at least approximately 1×10¹⁷cm⁻³ and a carrier mobility of at least approximately 20 cm²/Vs.

In some examples, the "material" selected for forming the thin film and thus for forming the active layer may also be referred to as an "active layer material", or sometimes a "direct-current-sputtered material" or a "DC-sputtered material". The thin film may also be referred to as an "active layer thin film".

Conventional methods for forming oxide-based semiconductor materials include a radio frequency (RF) sputtering process. Compared with a DC sputtering process, an RF sputtering process has disadvantages of slowness, requiring adjustments, poor repeatability, uneven composition of pluralistic film, and large RF radiation. Thus, the RF sputtering process is not widely used in the industry. Moreover, most oxide-based semiconductor materials are susceptible to acid and likely to be corroded during etching process, making it impractical to form source electrode and drain electrode on oxide-based semiconductor materials by direct etching. As a result, use of oxide-based semiconductor materials has limitations in massive applications.

As such, in some examples, an exemplary active layer is formed by a DC sputtering process using a selected material. In this case, the active layer has desired carrier concentration and carrier mobility. The combination of the DC sputtering process with the selected material for the active layer may overcome difficulties often occurred in conventional processes. For example, as disclosed herein, arcing discharge phenomenon caused by defects in a conventional method may not occur.

In various examples, in addition to forming the active layer by a DC sputtering process, gate electrode and source/drain electrodes may also be formed using DC sputtering processes to form a desired thin film transistor (TFT). In some cases, the entire thin film transistor may be produced mainly by the DC sputtering processes. This may significantly simplify the entire TFT process and may be a breakthrough solution in TFT technology.

The selected active layer material may include, for example, zirconium indium oxide, hafnium zinc oxide, indium tin oxide, zinc oxide, Ln-doped zinc oxide, and a combination thereof.

In one example, the active layer is made of zirconium indium oxide. The chemical formula of zirconium indium oxide may include ZrₓIn₁₀₀₋ₓO_{y}, where 0.1≤x≤20 and y>0. For example, x may be 0.1, 0.3, 0.5, 0.7, 0.9, 1, 2, 3, 4, 5, 6, 7, 8, 9, 10, 11, 12, 13, 14, 15, 16, 17, 18, 19, 20, or any value between the disclosed range, and y may be 1, 5, 10, 15, 20, 25, 30, 35, 40, 45, 50, 55, 60, 65, 70, 75, 80, 85, 90, 95, 100, or any value in the disclosed range.

The zirconium indium oxide having the chemical structure ZrₓIn₁₀₀₋ₓO_{y} may have advantages of high mobility, wide optical band gap, high stability, and superior conductivity. A zirconium indium oxide thin film formed by direct current (DC) sputtering may have the same advantages. Prior to annealing, the zirconium indium oxide thin film may be in an amorphous state, and may have a high acid etch rate, suitable for using wet etching patterning process. After annealing, the zirconium indium oxide thin film may be changed from the amorphous state to a crystalline state. At this point, the zirconium indium oxide thin film may have a substantially low acid etch rate or otherwise unsusceptible to acid, eliminating the need for configuring an etch barrier layer. When the source and drain electrodes are formed on the zirconium indium oxide thin film by using direct etching patterning process, the active layer may not be etched.

When the active layer has the characteristics described above, a thin film transistor incorporating such active layer may use the DC sputtering process entirely to form the corresponding gate electrode, active layer, source electrode and drain electrode sequentially. In addition, the gate insulating layer may be directly formed by using an electrochemical oxidation process after the gate electrode is formed. In this case, thin film transistors may be formed in various types of structures, such as bottom-gate staggered structure. Such thin film transistors may have high carrier mobility, desired electrical uniformity, and controllable thickness for the gate insulating layer.

In one example, when the carrier concentration in the active layer is greater than or equal to approximately 1×10¹⁷cm⁻³, defects caused by arc discharge during the DC sputtering may be avoided. Preferably, the carrier concentration in the active layer may be greater than or equal to approximately 1×10¹⁸cm⁻³. The carrier mobility in the active layer is greater or equal to approximately 20cm²/Vs. Preferably, the carrier mobility in the active layer may be greater than or equal to approximately 30cm²/Vs. The active layer described above may also have high conductivity, making it more suitable for DC sputtering deposition. Thus, the film formation rate can be improved, fabrication process can be simplified, and film formation cost can be reduced.

Further, when the active layer is submerged in a phosphoric acid with a concentration ratio by weight of approximately 40% to 60%, for example about 50%, the etching rate may be greater than or equal to approximately 60nm/min. When the active layer is annealed at approximately 150°C to 220°C, for example, about 160°C, 180°C, or 200°C, for approximately 30 minutes, the etching rate of the active layer in a phosphoric acid with a concentration ratio by weight of approximately 40% to 60% is dropped to be less than or equal to 10nm/min.

As such, the active layer according to the present disclosure has a high acid etching rate before annealing and a low acid etching rate after annealing. After annealing, the active layer is acid-resistant. The active layer is wet etched by a patterning process before annealing. After the active layer is annealed, when source electrode and drain electrode are formed on the active layer by a patterning process, the active layer is not etched by the etching acid, making it suitable for forming back-channel-etched oxide thin film transistor.

The present disclosure also provides a thin film transistor. The thin film transistor includes the disclosed active layer.

Because the disclosed active layer material is used, the thin film transistor according to the present disclosure may be formed by a whole-DC sputtering process. A gate electrode, an active layer, a source electrode and a drain electrode may be formed sequentially. In addition, a gate insulating layer may be directly formed by using an electrochemical oxidation process after the gate electrode is formed. In this case, the thin film transistor may be formed in various types of structures, such as bottom-gate staggered structure. Such thin film transistor may have high carrier mobility, desired electrical uniformity, and controllable thickness for gate insulating layer to increase adaptability in flat panel displays, such as liquid crystal displays (LCDs), and active matrix organic light emitting diode displays (AMOLEDs).

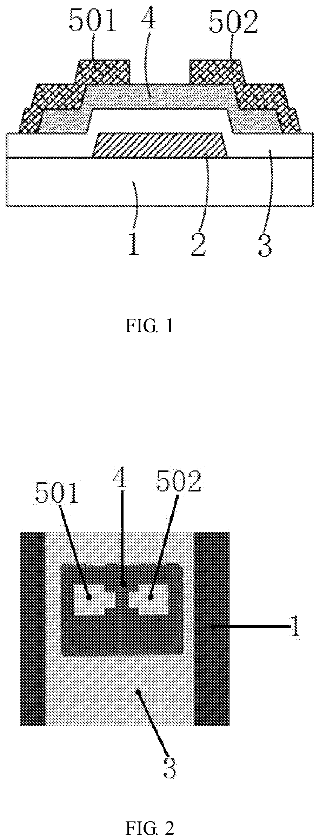

For example, the method of present invention provides a back-channel-etched oxide thin film transistor. FIG. 1 illustrates a schematic view of an exemplary back-channel-etched oxide thin film transistor according to various examples of the present disclosure. FIG. 2 illustrates a polarizing microscope scanning view of another exemplary back-channel-etched oxide thin film transistor according to various embodiments of the present disclosure. As shown in FIGS. 1-2, having a widely used bottom-gate staggered structure, the thin film transistor may include a substrate 1, a gate electrode 2, a gate insulating layer 3, an active layer 4, a source electrode 501, and a drain electrode 502.

The gate electrode 2 is formed on the substrate 1. The gate insulating layer 3 is configured on the substrate 1 to cover the gate electrode 2. The active layer 4 is configured on the gate insulating layer 3, corresponding to the gate electrode 2. The source electrode 501 and the drain electrode 502 are electrically connected to both ends of the active layer 4, respectively. In addition, a back channel structure is formed on the active layer 4. Alternatively, both source electrode 501 and drain electrode 502 may be configured on one end of the gate insulating layer 3.

Specifically, the substrate 1 may be a glass substrate, a flexible polymer substrate, a silicon wafer, a metal foil, a quartz substrate, or other appropriate material substrate. The gate electrode 2 may be an aluminum layer, an aluminum alloy layer, a tantalum layer, a tantalum alloy layer, a molybdenum layer, a stack of two or more sub-layers of combination selected from aluminum, aluminum alloy, tantalum, tantalum alloy, or any suitable gate structures.

The active layer 4 may be made of the disclosed zirconium indium oxide. An insulating oxide layer may be directly formed on the gate electrode 2 as the gate insulating layer 3. That is, the gate insulating layer 3 may be made of insulating oxide formed by an electrochemical oxidation process. For example, the insulating oxide may be aluminum oxide, molybdenum oxide, tantalum oxide, or aluminum neodymium oxide.

For the fabrication of the back-channel-etched oxide thin film transistor, the source electrode 501 and the drain electrode 502 may be made of conductive metal that can be etched by acid. For example, the conductive metal may be aluminum, molybdenum, tantalum, or aluminum neodymium alloy. In one example, the source electrode 501 and the drain electrode 502 may directly contact the active layer without an etch barrier layer there-between.

Further, in one example, the substrate 1 may be coated with a buffer layer or a water-oxygen-barrier layer to increase the barrier ability of the substrate. For example, the buffer layer may be made of silicon nitride, silicon oxide, silicon oxynitride, and aluminum oxide, etc.

In another example, in the thin film transistor according to the present disclosure, the gate electrode 2 has a thickness of approximately 100nm to 800nm. For example, the gate electrode 2 may have a thickness of 150nm, 200nm, 300nm, 400nm, 500nm, 600nm, or 700nm, etc. The gate insulating layer 3 has a thickness of approximately 30nm to 600nm. For example, the gate electrode layer 3 may have a thickness be 50nm, 100nm, 150nm, 200nm, 300nm, 400nm, or 500nm, etc. The active layer 4 has a thickness of approximately 10nm to 200nm. For example, the active layer 4 may have a thickness of 20nm, 40nm, 60nm, 80nm, 100nm, 130nm, 150nm, or 180nm, etc.

The source electrode 501 and the drain electrode 502 have a thickness of approximately 100nm to 1000nm. For example, the source electrode 501 and drain electrode 502 may have a thickness of 150nm, 200nm, 300nm, 400nm, 500nm, 600nm, 700nm, 800nm, or 900nm, etc. The back channel has a width of approximately 3µm to 30µm. For example, the back channel may have a width of 5 µm, 10 µm, 15 µm, 20 µm, or 25 µm, etc. By adjusting the thicknesses of each component of the thin film transistor, the thin film transistor may achieve different properties and performances. Thus, such thin film transistor is adaptable to various applications.

The present disclosure also provides an array substrate. The array substrate includes any of the disclosed thin film transistors. In one example, the array substrate according to the present disclosure has the advantages of high carrier mobility and desired electrical uniformity.

The present disclosure also provides a display apparatus. The display apparatus includes any of the disclosed array substrates. In one example, the display apparatus according to the present disclosure has the advantages of high carrier mobility and desired electrical uniformity.

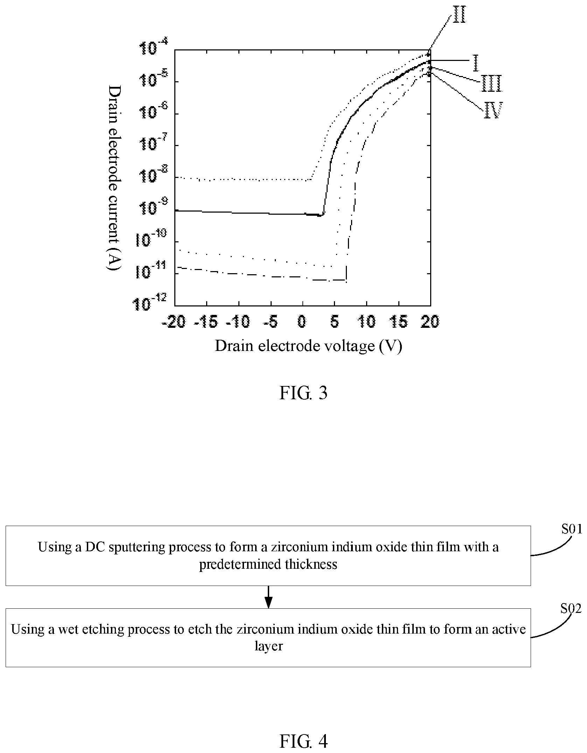

The present disclosure also provides a fabrication method for an active layer. FIG. 4 illustrates a flow chart of a fabrication method for an exemplary active layer according to the present disclosure. As shown in FIG. 4, the fabrication method for the active layer includes the following steps.

Step S01: using a DC sputtering process to form a zirconium indium oxide thin film with a predetermined thickness.

Specifically, a DC sputtering process is used to form a zirconium indium oxide thin film with a predetermined thickness. In one embodiment, the chemical formula of zirconium indium oxide is ZrₓIn₁₀₀₋ₓO_{y}, where 0.1≤x≤20 and y>0.

Step S02: using a wet etching patterning process to etch the zirconium indium oxide thin film to form an active layer.

The fabrication method for the active layer according to the present disclosure has the advantages of high film formation rate and simplified fabrication process. In addition, the absence of the barrier layer on the active layer reduces film formation cost.

Further, after the zirconium indium oxide thin film is wet etched in a phosphoric acid with a concentration ratio by weight of approximately 40% to 60%, the zirconium indium oxide thin film is annealed at approximately 150°C to 220°C for approximately 30 minutes to form the desired active layer. As evidence, after the active layer is annealed, the active layer is changed from an amorphous state to a crystalline state, which has high acid resistance.

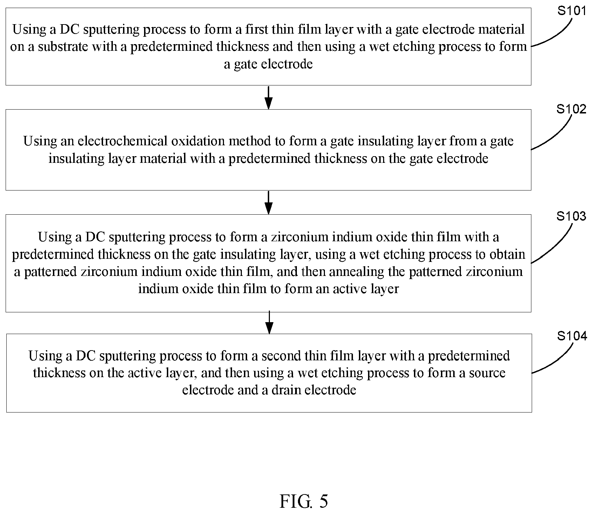

The present disclosure also provides a fabrication method for a thin film transistor. FIG. 5 illustrates a flow chart of a fabrication method for an exemplary thin film transistor according to the present disclosure. As shown in FIG. 5, the fabrication method includes the following steps.

Step S101: using a DC sputtering process to form a first thin film layer with a gate electrode material on a substrate with a predetermined thickness and then using a wet etching patterning process to form the gate electrode.

For example, a first thin film layer is formed on a substrate by using a DC sputtering process. The first thin film layer is then etched by a wet etching patterning process to form a first patterned thin film layer. The first patterned thin film layer has a shape of a gate electrode.

Step S102: using an electrochemical oxidation method to form a gate insulating layer from the gate insulating layer material with a predetermined thickness on the gate electrode.

For example, a gate insulating layer may be directly formed by using an electrochemical oxidation process after the gate electrode is formed. In this case, the thin film transistor may be formed in various types of structures, such as a bottom-gate staggered structure. Such thin film transistor may have high carrier mobility, desired electrical uniformity, and controllable thickness of gate insulating layer.

Step S103: using a DC sputtering process to form a zirconium indium oxide thin film with a predetermined thickness on the gate insulating layer, using a wet etching patterning process to obtain a patterned zirconium indium oxide thin film, and then annealing the patterned zirconium indium oxide thin film to form an active layer.

For example, a zirconium indium oxide thin film with a predetermined thickness is formed on the gate insulating layer by using a DC sputtering process. The zirconium indium oxide thin film is then etched by a wet etching patterning process to form a patterned zirconium indium oxide thin film. The patterned zirconium indium oxide thin film has a shape of an active layer. The zirconium indium oxide has a chemical formula as ZrₓIn₁₀₀₋ₓO_{y}, where 0.1≤x≤20 and y>0.

Step S104: using a DC sputtering process to form a second thin film layer with a predetermined thickness on the active layer, and then using a wet etching patterning process to form a source electrode and a drain electrode.

For example, a second thin film layer with a predetermined thickness is formed on the active layer by using a DC sputtering process. The second thin film layer is then etched by a wet etching patterning process to form a source electrode and a drain electrode.

Further, when forming the first thin film layer, the zirconium indium oxide thin film, and the second thin film layer, multiple steps of DC sputtering process may be used to deposit multiple layers to reach a predetermined thickness depending on the actual design requirement. The DC sputtering process and the electrochemical oxidation process are used herein for fabricating thin film transistors without limitations.

For example, an electrochemical oxidation process may include the following steps. A substrate formed with gate electrodes is submerged or inserted into an electrolyte solution at one side, and is electrically connected to an anode of power source. A conductive metal as a material to form a gate insulating layer is submerged at the other side of the electrolyte solution, and is electrically connected to a cathode of power source. Then an electrical current is supplied through the anode and the cathode to perform electrochemical oxidation to form an insulating oxide of the conductive metal on the gate electrode and any exposed surface of the substrate. The metal oxide layer is used as gate insulating layer. The above example is for illustration purposes only and does not limit the specific details of the metal oxidation operation principle.

The fabrication process of thin film transistors according to the present disclosure uses a DC sputtering process to form a gate electrode, uses an electrochemical oxidation process to form a gate insulating layer on the gate electrode, and then uses a DC sputtering process to form an active layer, a source electrode and a drain electrode, sequentially. The source electrode and the drain electrode are directly formed on the active layer by using a wet etching patterning process without damaging the active layer. As a result, various types of thin film transistor structures may be formed with a controlled thickness of gate insulating layer. Such fabrication process is simple, low cost, and suitable for widespread adoption.

More examples are given to further illustrate the present invention. When no specific conditions are mentioned in any operations, normal operation conditions or manufacturer recommended conditions may be assumed. When a material is not specified or not identified with specific manufacturer, such material will be assumed to be a commercially available product.

In one embodiment, the method of the present invention provides an active layer. The thickness of the active layer is approximately 20nm. The active layer is made of zirconium indium oxide, with an approximate chemical formula Zr₁In₉₁O₁₀₀. The carrier concentration is approximately 1.5×10¹⁸cm⁻³. The carrier mobility is approximately 31cm²/Vs. Before being annealed, the active layer has an etching rate equal to approximately 60nm/min in a concentration of approximate 50% by weight phosphoric acid solution. After being annealed in air at approximately 200°C temperature for approximately 30 minutes, the active layer has an etching rate equal to 5nm/min in the phosphoric acid solution.

In another embodiment, the method of the present invention provides an active layer. The thickness of the active layer is approximately 25nm. The active layer is made of zirconium indium oxide, with an approximate chemical formula Zr₆In₉₄O₁₀₀. The carrier concentration is approximately 1.0×10¹⁸cm⁻³. The carrier mobility is approximately 30cm²/Vs. Before being annealed, the active layer has an etching rate equal to approximately 65nm/min in a phosphoric acid solution having a concentration of approximate 50% by weight. After being annealed in air at approximately 210°C temperature for approximately 35 minutes, the active layer has an etching rate equal to approximately 4nm/min in the phosphoric acid solution.

In another embodiment, the method of the present invention provides an active layer. The thickness of the active layer is approximately 22nm. The active layer is made of zirconium indium oxide, with an approximate chemical formula Zr₁₁In₈₉O₁₀₀. The carrier concentration is approximately 2.5×10¹⁹cm⁻³. The carrier mobility is approximately 35cm²/Vs. Before being annealed, the active layer has an etching rate equal to approximately 63nm/min in a phosphoric acid solution having concentration of approximate 50% by weight. After being annealed in air at approximately 210°C temperature for approximately 30 minutes, the active layer has an etching rate equal to approximately 3nm/min in the phosphoric acid solution.

In another embodiment, the present invention provides an active layer. The thickness of the active layer is approximately 20nm. The active layer is made of zirconium indium oxide, with an approximate chemical formula Zr₁₆In₈₄O₁₀₀. The carrier concentration is approximately 1.0×10²⁰cm⁻³. The carrier mobility is approximately 55cm²/Vs. Before being annealed, the active layer has an etching rate equal to approximately 67nm/min in a phosphoric acid solution having concentration of approximate 50% by weight. After being annealed in air at approximately 200°C temperature for approximately 30 minutes, the active layer has an etching rate equal to approximately 3.5nm/min in the phosphoric acid solution.

In another embodiment, the present invention provides a back-channel-etched oxide thin film transistor. The thin film transistor has a bottom-gate staggered structure. The thin film transistor includes a substrate, a gate electrode, a gate insulating layer, an active layer, a source electrode and a drain electrode. The substrate is a glass substrate with a thickness of approximately 0.7mm. The gate electrode is formed on the substrate, is made of aluminum, and has a thickness of approximately 300nm.

The gate insulating layer formed on the substrate to cover the gate electrode is made of aluminum oxide, and has a thickness of approximately 200nm. The active layer is formed on the gate insulating layer, corresponding to the gate electrode. The source electrode and the drain electrode are electrically connected to both ends of the active layer, respectively, to form an approximate 5µm thick back channel on the active layer. The source electrode and the drain electrode are also located at both ends of the gate insulating layer. The source electrode and the drain electrode are made of aluminum, with a thickness of approximately 500nm.

The fabrication method for the above back-channel-etched oxide thin film transistor includes the following steps.

Step S201: using a DC sputtering process to deposit an approximate 300nm thick aluminum thin film on a substrate and then using a phosphoric acid having a concentration of approximate 50% by weight to etch the aluminum thin film to form a gate electrode.

Step S202: using an electrochemical oxidation process to form an approximate 200nm thick aluminum oxide thin film on the gate electrode as a gate insulating layer.

Step S203: using a DC sputtering process to form an approximate 20nm thick zirconium indium oxide thin film on the gate insulating layer, using phosphoric acid having a concentration of approximate 50% by weight to etch the zirconium indium oxide thin film to form a patterned zirconium indium oxide thin film, and then annealing the patterned zirconium indium oxide thin film in air at approximately 200°C temperature for approximately 30 minutes to form an active layer.

Step S204: using a DC sputtering process to form an approximate 500nm thick aluminum thin film on the active layer and then using phosphoric acid having a concentration of approximate 50% by weight to etch the aluminum thin film to form a source electrode and a drain electrode.

In another embodiment, the method of the present invention provides a back-channel-etched oxide thin film transistor. The thin film transistor has a bottom-gate staggered structure. The thin film transistor includes a substrate, a gate electrode, a gate insulating layer, an active layer, a source electrode and a drain electrode. The substrate is a quartz substrate with a thickness of approximately 0.7mm. The substrate is covered with an approximate 50nm thick aqueous oxygen barrier layer. The gate electrode is formed on the substrate, is made of tantalum, and has a thickness of approximately 400nm.

The gate insulating layer formed on the substrate to cover the gate electrode is made of tantalum oxide, and has a thickness of approximately 350nm. The active layer is formed on the gate insulating layer, corresponding to the gate electrode. The source electrode and the drain electrode are electrically connected to both ends of the active layer, respectively, to form an approximate 6µm thick back channel on the active layer. The source electrode and the drain electrode are also located at both ends of the gate insulating layer. The source electrode and the drain electrode are made of tantalum, with a thickness of approximately 700nm.

The fabrication method for the above back-channel-etched oxide thin film transistor includes the following steps.

Step S301: using a DC sputtering process to deposit an approximate 400nm thick tantalum thin film on a substrate and then using phosphoric acid having a concentration of approximate 50% by weight to etch the tantalum thin film to form a gate electrode.

Step S302: using an electrochemical oxidation process to form an approximate 350nm thick tantalum oxide thin film on the gate electrode as a gate insulating layer.

Step S303: using a DC sputtering process to form an approximate 25nm thick zirconium indium oxide thin film on the gate insulating layer, using phosphoric acid having a concentration of approximate 50% by weight to etch the zirconium indium oxide thin film to form a patterned zirconium indium oxide thin film, and then annealing the patterned zirconium indium oxide thin film in air at approximately 200°C temperature for approximately 30 minutes to form an active layer.

Step S304: using a DC sputtering process to form an approximate 700nm thick tantalum thin film on the active layer and then using phosphoric acid having a concentration of approximate 50% by weight to etch the tantalum thin film to form a source electrode and a drain electrode.

In another embodiment, the method of the present invention provides a back-channel-etched oxide thin film transistor. The thin film transistor has a bottom-gate staggered structure. The thin film transistor includes a substrate, a gate electrode, a gate insulating layer, an active layer, a source electrode and a drain electrode. The substrate is a glass substrate with a thickness of approximately 0.7mm. The gate electrode is formed on the substrate, is made of aluminum, and has a thickness of approximately 300nm.

The gate insulating layer formed on the substrate to cover the gate electrode is made of aluminum oxide, and has a thickness of approximately 200nm. The active layer is formed on the gate insulating layer, corresponding to the gate electrode. The source electrode and the drain electrode are electrically connected to both ends of the active layer, respectively, to form an approximate 3µm thick back channel on the active layer. The source electrode and the drain electrode are also located at both ends of the gate insulating layer. The source electrode and the drain electrode are made of aluminum, with a thickness of approximately 500nm.

The fabrication method for the above back-channel-etched oxide thin film transistor includes the following steps.

Step S401: using a DC sputtering process to deposit an approximate 300nm thick aluminum thin film on a substrate and then using phosphoric acid having a concentration of approximate 50% by weight to etch the aluminum thin film to form a gate electrode.

Step S402: using an electrochemical oxidation process to form an approximate 200nm thick aluminum oxide thin film on the gate electrode as a gate insulating layer.

Step S403: using a DC sputtering process to form an approximate 20nm thick zirconium indium oxide thin film on the gate insulating layer, using phosphoric acid having a concentration of approximate 50% by weight to etch the zirconium indium oxide thin film to form a patterned zirconium indium oxide thin film, and then annealing the patterned zirconium indium oxide thin film in air at approximately 200°C temperature for approximately 30 minutes to form an active layer.

Step S404: using a DC sputtering process to form an approximate 500nm thick aluminum thin film on the active layer and then using phosphoric acid having a concentration of approximate 50% by weight to etch the aluminum thin film to form a source electrode and a drain electrode.

In another embodiment, the method of the present invention provides a back-channel-etched oxide thin film transistor. The thin film transistor has a bottom-gate staggered structure. The thin film transistor includes a substrate, a gate electrode, a gate insulating layer, an active layer, a source electrode and a drain electrode. The substrate is a glass substrate with a thickness of approximately 0.7mm. The gate electrode is formed on the substrate, is made of aluminum, and has a thickness of approximately 300nm.

The gate insulating layer formed on the substrate to cover the gate electrode is made of aluminum oxide, and has a thickness of approximately 200nm. The active layer is formed on the gate insulating layer, corresponding to the gate electrode. The source electrode and the drain electrode are electrically connected to both ends of the active layer, respectively, to form an approximate 4.3µm thick back channel on the active layer. The source electrode and the drain electrode are also located at both ends of the gate insulating layer. The source electrode and the drain electrode are made of aluminum, with a thickness of approximately 500nm.

The fabrication method for the above back-channel-etched oxide thin film transistor includes the following steps.

Step S501: using a DC sputtering process to deposit an approximate 300nm thick aluminum thin film on a substrate and then using phosphoric acid having a concentration of approximate 50% by weight to etch the aluminum thin film to form a gate electrode.

Step S502: using an electrochemical oxidation process to form an approximate 200nm thick aluminum oxide thin film on the gate electrode as a gate insulating layer.

Step S503: using a DC sputtering process to form an approximate 20nm thick zirconium indium oxide thin film on the gate insulating layer, using phosphoric acid having a concentration of approximate 50% by weight to etch the zirconium indium oxide thin film to form a patterned zirconium indium oxide thin film, and then annealing the patterned zirconium indium oxide thin film in air at approximately 200°C temperature for approximately 30 minutes to form an active layer.

Step S504: using a DC sputtering process to form an approximate 500nm thick aluminum thin film on the active layer and then using phosphoric acid having a concentration of approximate 50% by weight to etch the aluminum thin film to form a source electrode and a drain electrode.

In another embodiment, each of the back-channel-etched oxide thin film transistors illustrated in the above examples is measured to obtain a plurality of output characteristics curves, respectively. FIG. 3 illustrates output characteristics curves of certain exemplary back-channel-etched oxide thin film transistors according to the present disclosure. As shown in FIG. 3, the output characteristics curves represent the relationships between the drain electrode current (in Ampere) and the drain electrode voltage (in Volt) under different gate electrode voltages (in Volt), corresponding to different back-channel-etched oxide thin film transistors according to various embodiments. The four output characteristics curves have similar shapes, but do not intersect with each other.

Curve I corresponds to a back-channel-etched oxide thin film transistor formed by a fabrication process with steps S201 through S204. Curve II corresponds to a back-channel-etched oxide thin film transistor formed by a fabrication process with steps S301 through S304. Curve III corresponds to a back-channel-etched oxide thin film transistor formed by a fabrication process with steps S401 through S404. Curve IV corresponds to a back-channel-etched oxide thin film transistor formed by a fabrication process with steps S501 through S504. As shown in FIG. 3, the gate electrode voltage of the back-channel-etched oxide thin film transistor according to the present disclosure may be adjusted to control the drain electrode current to achieve desirable output characteristics. Array substrates and display apparatus incorporating the disclosed thin film transistors may have desired performance and quality.

Various examples have been described to illustrate the operation principles and exemplary implementations. The embodiments disclosed herein are exemplary only. Other applications, advantages, alternations, modifications, or equivalents to the disclosed embodiments are obvious to those skilled in the art and are intended to be encompassed within the scope of the present disclosure. The scope of the invention is defined by the following claims.

## Claims

1. A method for fabricating a thin film transistor, comprising:
forming a thin film by a direct current (DC) sputtering process; and
etching the thin film by a weting etching process to form an active layer (4), wherein the active layer is made of zirconium indium oxide and has a carrier concentration of at least approximately 1×10¹⁷cm⁻³ and a carrier mobility of at least approximately 20 cm²/Vs,
the zirconium indium oxide has a chemical formula of Zr₆In₉₄O₁₀₀, Zr₁₁In₈₉O₁₀₀ or Zr₁₆In₈₄O₁₀₀, and
the wet etching process comprises:
etching the thin film made of zirconium indium oxide at an etching rate of greater than or equal to 60 nm/min in a phosphoric acid solution having concentration of 50 % by weight; and
annealing the thin film made of zirconium indium oxide in air at a temperature 200 °C for at least 30 minutes after etching the thin film made of zirconium indium oxide.

2. The method according to claim 1, wherein:
the carrier concentration of the active layer (4) is greater than or equal to approximately 1×10¹⁸cm⁻³; and
the carrier mobility of the active layer (4) is greater than or equal to approximately 30cm²/Vs.

3. The method according to claim 1, further comprising:
before forming the active layer (4), forming a gate electrode thin film on a substrate (1) by a direct current (DC) sputtering process;
etching the gate electrode thin film to form a gate electrode (2);
forming a gate insulating layer (3) on the gate electrode (2);
after forming the active layer (4), forming a source/drain thin film by a DC sputtering process on the active layer (4); and
etching the source/drain thin film to form a source electrode (501) and a drain electrode (502).

4. The method according to claim 3, wherein:
the carrier concentration of the active layer (4) is greater than or equal to approximately 1×10¹⁸cm⁻³, and
the carrier mobility of the active layer (4) is greater than or equal to approximately 30cm²/Vs.

5. The method according to claim 3, wherein:
the gate insulating layer (3) is formed by an electrochemical oxidation method on the gate electrode (2).

6. The method according to claim 3, wherein each of etching the gate electrode thin film and etching the source/drain thin film includes a wet etching process.

## Patentansprüche

1. Verfahren zur Herstellung eines Dünnschichttransistors, umfassend:
Bilden einer Dünnschicht durch einen Gleichstrom-(DC)-Sputtervorgang; und
Ätzen der Dünnschicht durch einen Nassätzvorgang, um eine aktive Schicht (4) zu bilden, wobei die aktive Schicht aus Zirkonium-Indium-Oxid hergestellt ist und eine Ladungsträgerkonzentration von mindestens etwa 1×10¹⁷ cm⁻³ und eine Ladungsträgerbeweglichkeit von mindestens etwa 20 cm²/Vs aufweist,
wobei das Zirkonium-Indium-Oxid eine chemische Formel von Zr₆In₉₄O₁₀₀, Zr₁₁In₈₉O₁₀₀ oder Zr₁₆In₈₄O₁₀₀ aufweist, und
der Nassätzvorgang umfasst:
Ätzen der aus Zirkonium-Indium-Oxid hergestellten Dünnschicht mit einer Ätzrate von größer als oder gleich 60 nm/min in einer Phosphorsäurelösung mit einer Konzentration von 50 Gew.-%; und
Tempern der aus Zirkonium-Indium-Oxid hergestellten Dünnschicht in Luft bei einer Temperatur von 200 °C für mindestens 30 Minuten nach dem Ätzen der aus Zirkonium-Indium-Oxid hergestellten Dünnschicht.

2. Verfahren nach Anspruch 1, wobei:
die Ladungsträgerkonzentration der aktiven Schicht (4) größer als oder gleich etwa 1×10¹⁸ cm⁻³ ist; und
die Ladungsträgerbeweglichkeit der aktiven Schicht (4) größer als oder gleich etwa 30 cm²/Vs ist.

3. Verfahren nach Anspruch 1, ferner umfassend:
vor dem Bilden der aktiven Schicht (4), Bilden einer Gate-Elektroden-Dünnschicht auf einem Substrat (1) durch einen Gleichstrom-(DC)-Sputtervorgang;
Ätzen der Gate-Elektroden-Dünnschicht, um eine Gate-Elektrode (2) zu bilden;
Bilden einer Gate-Isolierschicht (3) auf der Gate-Elektrode (2);
nach dem Bilden der aktiven Schicht (4), Bilden eines Source/Drain-Dünnschicht durch einen DC-Sputtervorgang auf der aktiven Schicht (4); und
Ätzen des Source/Drain-Dünnschicht, um eine Source-Elektrode (501) und eine Drain-Elektrode (502) zu bilden.

4. Verfahren nach Anspruch 3, wobei:
die Ladungsträgerkonzentration der aktiven Schicht (4) größer als oder gleich etwa 1×10¹⁸ cm⁻³ ist, und
die Ladungsträgerbeweglichkeit der aktiven Schicht (4) größer als oder gleich etwa 30 cm²/Vs ist.

5. Verfahren nach Anspruch 3, wobei:
die Gate-Isolierschicht (3) durch ein elektrochemisches Oxidationsverfahren auf der Gate-Elektrode (2) gebildet wird.

6. Verfahren nach Anspruch 3, wobei
sowohl das Ätzen der Gate-Elektroden-Dünnschicht als auch das Ätzen der Source/Drain-Dünnschicht einen Nassätzvorgang umfasst.

## Revendications

1. Procédé de fabrication d'un transistor à couches minces, comprenant les étapes consistant à :
former un film mince par un procédé de pulvérisation en courant continu (DC) ; et
graver la couche mince par un processus de gravure humide pour former une couche active (4), dans lequel la couche active est constituée d'oxyde de zirconium-indium et a une concentration en porteurs d'au moins approximativement 1 × 10¹⁷ cm ⁻³ et une mobilité de porteurs d'au moins environ 20 cm ² /Vs,
l'oxyde de zirconium-indium a une formule chimique Zr₆In₉₄O₁₀₀, Zr₁₁In₈₉O₁₀₀ ou Zr₁₆In₈₄O₁₀₀, et
le procédé de gravure humide comprend les étapes consistant à :
graver la couche mince constituée d'oxyde de zirconium-indium à une vitesse de gravure supérieure ou égale à 60 nm/min dans une solution d'acide phosphorique ayant une concentration de 50 % en poids ; et
recuire la couche mince constituée d'oxyde de zirconium indium dans l'air à une température de 200°C pendant au moins 30 minutes après la gravure de la couche mince constituée d'oxyde de zirconium indium.

2. Procédé selon la revendication 1, dans lequel :
la concentration en porteurs de la couche active (4) est supérieure ou égale à environ 1 × 10 ¹⁸ cm ⁻³ ; et
la mobilité des porteurs de la couche active (4) est supérieure ou égale à environ 30 cm ² /Vs.

3. Procédé selon la revendication 1, comprenant en outre les étapes consistant à :
avant de former la couche active (4), former un film mince d'électrode de grille sur un substrat (1) par un processus de pulvérisation en courant continu (DC) ;
graver la couche mince d'électrode de grille pour former une électrode de grille (2) ;
former une couche isolante de grille (3) sur l'électrode de grille (2) ;
après formation de la couche active (4), former une couche mince de source/drain par un processus de pulvérisation DC sur la couche active (4) ; et
graver la couche mince de source/drain pour former une électrode de source (501) et une électrode de drain (502).

4. Procédé selon la revendication 3, dans lequel :
la concentration en porteurs de la couche active (4) est supérieure ou égale à environ 1 × 10 ¹⁸ cm ⁻³, et la mobilité des porteurs de la couche active (4) est supérieure ou égale à environ 30 cm ² /Vs.

5. Procédé selon la revendication 3, dans lequel :
la couche isolante de grille (3) est formée par un procédé d'oxydation électrochimique sur l'électrode de grille (2).

6. Procédé selon la revendication 3, dans lequel
chaque gravure parmi la gravure de la couche mince d'électrode de grille et la gravure de la couche mince de source/drain comprend un processus de gravure humide.
